# EUROPÄISCHE PATENTANMELDUNG

(11) **EP 3 660 948 A1**
(43) Veröffentlichungstag der Anmeldung: **03.06.2020**
(21) Anmeldenummer: 19198604.1
(22) Anmeldetag: 20.09.2019
(51) Int. Cl.: H01M 2/10, H01M 10/04, H01M 2/02, H01M 2/20, H01M 2/22, G01R 31/36

(54) **BATTERIEZELLHALTER, BATTERIEMODUL, FERTIGUNGSVERFAHREN UND MONTAGEVERFAHREN**

(30) Priorität: 13.11.2018 DE 102018219383
(71) Anmelder: Robert Bosch GmbH, 70442 Stuttgart (DE)
(72) Erfinder: Zielke, Christian, 72800 Eningen Unter Achalm (DE); Koeder, Thilo, 70839 Gerlingen (DE); Alisic, Haris, 72770 Reutlingen (DE)

(57) **Zusammenfassung**

Batteriezellhalter (200), aufweisend eine Vielzahl an Aufnahmepositionen (250), wobei jede Aufnahmeposition (250) dazu eingerichtet ist, eine Batteriezelle (100) aufzunehmen, wobei jede Aufnahmeposition (250) mindestens eine metallische Schneide (201) aufweist, wobei die Schneide (201) dazu eingerichtet ist, beim Einfügen (530) einer Batteriezelle (100) in die Aufnahmeposition (250) eine äußere elektrische Zellisolierung (102) der Batteriezelle (100) zu durchschneiden und einen elektrischen Kontakt zwischen einem metallischen Batteriezellgehäuse (101) der aufgenommenen Batteriezelle (100) und der Schneide (201) zu erzeugen.

## Beschreibung

Die vorliegende Erfindung betrifft einen Batteriezellhalter sowie ein Batteriemodul mit diesem Batteriezellhalter. Des Weiteren betrifft die Erfindung ein Fertigungsverfahren des Batteriezellhalters und ein Montageverfahren des Batteriemoduls.

### Stand der Technik

Aktuelle Batteriezellen, insbesondere zylindrische Batteriezellen der Typen 18650, 20700 oder 2170, weisen typischerweise ein metallisches Batteriezellgehäuse auf, welche als Dose ausgestaltet sein kann. Durch dieses metallische Batteriezellgehäuse werden die Chemikalien im Inneren der Batteriezelle zur Umgebung hin abgedichtet. Das metallische Batteriezellgehäuse wird meist mit einem der zwei elektrischen Pole der Batteriezelle elektrisch leitfähig verbunden. Um bei einer Lagerung der Batteriezelle und/oder einem Transport der Batteriezelle und/oder einer Verwendung der Batteriezelle und/oder bei Kontakt mit metallischen Gegenständen Kurzschlüsse zu vermeiden, wird das metallische Batteriezellgehäuse meist zusätzlich mittels einer äußeren elektrischen Zellisolierung umhüllt. Diese Zellisolierung weist vorteilhafterweise ein Polymermaterial auf. Vorzugsweise umfasst die Zellisolierung einen Schrumpfschlauch oder eine Lackierung.

In einem Batteriemodul, insbesondere für Hochstromanwendungen, ist es wünschenswert, dass eine Spannung jeder einzelnen Batteriezelle überwacht wird. Diese Spannungsmessung jeder Batteriezelle wird auch Single Cell Monitoring beziehungsweise Einzelzellüberwachung genannt. Dadurch kann beispielsweise eine defekte Batteriezelle frühzeitig erkannt werden. Die frühzeitige Erkennung eines Defektes auf Betteriezellebene beziehungsweise einer Batteriezelle erlaubt beispielsweise eine Anpassung der Lade- und/oder Entladeströme und/oder einen frühzeitigen Austausch der defekten Batteriezelle und/oder eine Vermeidung eines thermischen Runaways beziehungsweise einer Explosion der defekten Batteriezelle.

Die Aufgabe der vorliegenden Erfindung ist es, einen Batteriezellhalter beziehungsweise ein Batteriemodul mit Einzelzellüberwachung zu verbessern.

### Offenbarung der Erfindung

Die vorliegende Aufgabe wird gemäß der unabhängigen Ansprüche 1, 6, 8 und 11 gelöst.

Die vorliegende Erfindung betrifft einen Batteriezellhalter. Der Batteriezellhalter weist eine Vielzahl an Aufnahmepositionen auf. Jede Aufnahmeposition ist dazu eingerichtet, eine Batteriezelle aufzunehmen. Beispielsweise umfasst jede Aufnahmeposition eine Vertiefung zur Aufnahme einer Batteriezelle. Erfindungsgemäß weist jede Aufnahmeposition mindestens eine metallische Schneide auf, wobei die Schneide dazu eingerichtet ist, beim Einfügen einer Batteriezelle in die Aufnahmeposition eine äußere elektrische Zellisolierung der Batteriezelle zu durchschneiden und einen elektrischen Kontakt zwischen einem metallischen Batteriezellgehäuse der aufgenommenen Batteriezelle und der Schneide zu erzeugen. Das metallische Batteriezellgehäuse ist vorteilhafterweise mit einem elektrischen Pol der Batteriezelle verbunden. Durch diesen Batteriezellhalter entsteht der Vorteil, dass die elektrische Kontaktierung jeder Zelle zur Einzelzellüberwachung vereinfacht wird. Zusätzliche Kontaktierungen der Batteriezelle zur Erzeugung einer elektrischen Verbindung parallel zur Stromabführung können demnach entfallen.

In einer bevorzugten Ausführung weist der Batteriezellhalter eine Vielzahl an elektrischen Leitern auf, wobei jeder elektrische Leiter mit der Schneide einer Aufnahmeposition verbunden ist. Vorteilhafterweise sind die Schneide und der elektrische Leiter Teil eines metallischen Stanzgitters. Mit anderen Worten umfasst das metallische Stanzgitter sowohl die Schneide, welche gebogen und/oder gespitzt sein kann, als auch den elektrischen Leiter. Dadurch ist vorteilhafterweise eine einfache elektrische Kontaktierung einer Batteriezelle mittels der Schneide außerhalb des Batteriezellhalters durch elektrischen Kontakt zum elektrischen Leiter des Batteriezellhalters möglich.

In einer besonders bevorzugten Ausführung sind die elektrischen Leiter und/oder die Schneiden im Batteriezellhalter von einer Polymermatrix zumindest teilweise umschlossen. Mit anderen Worten sind die Schneide und/oder die elektrischen Leiter vorteilhafterweise in die Polymermatrix zumindest zum Teil eingebettet beziehungsweise fixiert. Dadurch entsteht der Vorteil einer einfachen Handhabung des Batteriezellhalters.

In einer Weiterführung ist die Schneide des Batteriezellhalters zusätzlich dazu eingerichtet, das metallische Batteriezellgehäuse der Batteriezelle beim Einfügen anzuritzen. Dadurch wird vorteilhafterweise eine zusätzliche Sollberststelle des metallischen Batteriezellgehäuses der Batteriezelle erzeugt. Über ein Aufreißen der Batteriezelle entlang des metallischen Batteriezellgehäuses beziehungsweise entlang des Zellmantels kann eine große Öffnung zur Abführung von Gase geschaffen werden. Dadurch kann das Ausmaß beziehungsweise die mechanische Wucht einer Explosion einer Batteriezelle im Notfall reduziert werden.

In einer weiteren Ausführung umfasst jede Aufnahmeposition mindestens ein Federelement, welches dazu eingerichtet ist, die aufgenommene Batteriezelle in der Vertiefung zu fixieren. Das Federelement ist vorteilhafterweise ein federelastischer Teil der Polymermatrix des Batteriezellhalters, welcher dazu eingerichtet sind, eine Kraft auf die Batteriezelle auszuüben und/oder Toleranzen der in einer Aufnahmeposition aufgenommenen Batteriezelle auszugleichen und/oder die Batteriezelle federnd zur Absorption von mechanischen Stößen in der Aufnahmeposition zu halten und/oder den elektrischen Kontakt zwischen einer aufgenommenen Batteriezelle und einer Schneide zu gewährleisten.

Die Erfindung betrifft außerdem ein Batteriemodul mit dem Batteriezellhalter und einer Vielzahl an Batteriezellen, wobei jede Batteriezelle jeweils in einer Aufnahmeposition des Batteriezellhalters aufgenommen ist. Jede aufgenommene Batteriezelle kontaktiert ferner mit einem metallischen Batteriezellgehäuse der Batteriezelle eine metallische Schneide des Batteriezellhalters elektrisch. Durch dieses Batteriemodul entsteht der Vorteil, dass die elektrische Kontaktierung der Batteriezellen zur Einzelzellüberwachung bereits durch das Einfügen der Batteriezellen in den Batteriezellhalter mittels der Schneide, das heißt sozusagen automatisch, erfolgt ist, so dass keine zusätzlichen Kontaktierungsschritte erforderlich sind.

In einer bevorzugten Ausgestaltung umfasst das Batteriemodul eine metallische Stromsammelschiene, welche dazu eingerichtet ist, jede Batteriezelle an einem elektrischen Pol, welcher nicht mit dem metallischen Batteriezellgehäuse der Batteriezelle verbunden ist, zu kontaktieren. Ferner weist das Batteriemodul in dieser Ausgestaltung ein Elektronikmodul auf, welches dazu eingerichtet ist, eine elektrische Spannungsmessung zwischen der Stromsammelschiene und einem elektrischen Leiter des Batteriezellhalters und/oder zwischen zwei verschiedenen elektrischen Leitern des Batteriezellhalters durchzuführen. Jeder elektrische Leiter ist dabei mittels der Schneide mit dem metallischen Batteriezellgehäuse einer Batteriezelle elektrisch leitfähig verbunden. Durch diese Ausgestaltung kann vorteilhafterweise eine Überwachung der Spannung jeder Batteriezelle beziehungsweise eine Einzelzellüberwachung des Batteriemoduls durchgeführt werden.

Die Erfindung betrifft auch ein Fertigungsverfahren des Batteriezellhalters. In einem ersten Schritt des Fertigungsverfahrens werden eine Vielzahl von metallischen Schneiden bereitgestellt. In einem weiteren Schritt werden die Schneiden in einer Spritzgussform zur Herstellung einer Polymermatrix des Batteriezellhalters umspritzt.

In einer vorteilhaften Ausgestaltung umfasst ein metallisches Stanzgitter die Schneiden und die elektrischen Leiter. Dadurch entsteht der Vorteil, dass die Vielzahl der metallischen Schneiden einstückig vor dem Spritzguss gehandhabt werden kann.

In einer bevorzugten Weiterführung des Fertigungsverfahrens werden die metallischen Verbindungen des Stanzgitters zwischen den Schneiden in einem anschließenden Schritt getrennt. Dadurch werden die elektrischen Verbindungen zwischen den Schneiden getrennt, so dass die Einzelzellüberwachung ermöglicht wird.

Die Erfindung betrifft ferner ein Montageverfahren eines Batteriemodus. In einem Schritt des Montageverfahrens wird der erfindungsgemäße Batteriezellhalter bereitgestellt. Demnach ist der Batteriezellhalter dazu eingerichtet, eine Vielzahl an Batteriezellen in jeweils einer Aufnahmeposition aufzunehmen, wobei jeder der Aufnahmepositionen mindestens eine metallische Schneide aufweist. Das Montageverfahren weist ferner eine Bereitstellung einer Vielzahl an Batteriezellen auf. Jede Batteriezelle umfasst ein metallisches Batteriezellgehäuse, welches zumindest zum Teil durch eine äußere elektrische Zellisolierung umhüllt ist. Jede Batteriezelle umfasst beispielsweise als äußere elektrische Zellisolierung bevorzugt einen Schrumpfschlauch, aufweisend ein Polymermaterial. Anschließend wird jede bereitgestellte Batteriezelle in jeweils eine Aufnahmeposition des Batteriezellhalters eingefügt beziehungsweise aufgenommen, wobei die Schneide des Batteriezellhalters die äußere elektrische Zellisolierung der Batteriezelle beim Einfügen durchschneidet und ein elektrischer Kontakt zwischen dem metallischen Batteriezellgehäuse der eingefügten beziehungsweise aufgenommen Batteriezelle und der metallischen Schneide des Batteriezellhalters erzeugt wird. Dadurch resultiert der Vorteil, dass eine elektrische Kontaktierung zwischen einer aufgenommenen Batteriezelle und einem elektrischen Leiter des Batteriezellhalters automatisch beim Montageverfahren zur Einzelzellüberwachung erzeugt wird.

In einer Weiterführung ritzt die Schneide das metallische Batteriezellgehäuse der Batteriezelle beim Einfügen der Batteriezelle in einer Aufnahmeposition des Batteriezellhalters an. Dadurch wird eine zusätzliche Sollberststelle der aufgenommenen Batteriezelle erzeugt, welche mechanische Auswirkungen einer im Notfall auftretenden Explosion der Batteriezelle abschwächt. Außerdem könnte durch diese Weiterführung auf die Erzeugung eines Sicherheitsventil der Batteriezelle verzichtet werden, wodurch die Batteriezelle günstiger gefertigt werden kann.

Weitere Vorteile ergeben sich aus der nachfolgenden Beschreibung von Ausführungsbeispielen mit Bezug zu den Figuren.
- Figur 1:: Batteriezelle
- Figur 2:: Batteriezellhalter
- Figur 3:: Batteriemodul mit dem Batteriezellhalter
- Figur 4:: Fertigungsverfahren des Batteriezellhalters
- Figur 5:: Montageverfahren des Batteriemoduls

### Ausführungsbeispiele

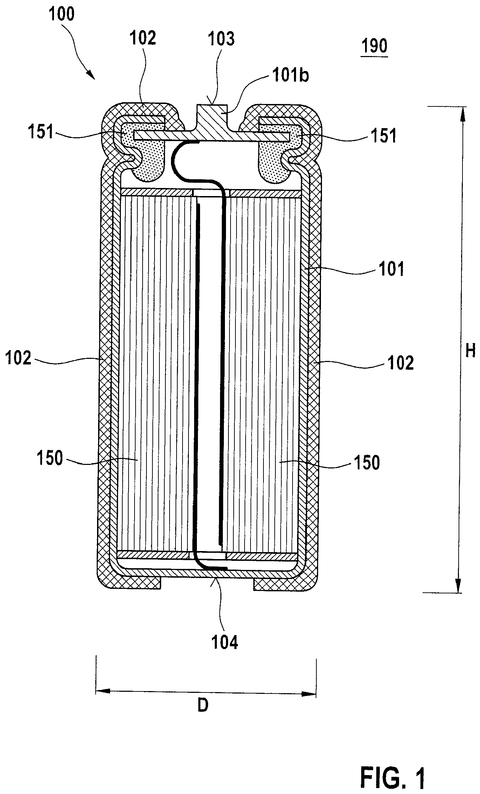

In Figur 1 ist ein schematisches Prinzip einer Batteriezelle 100 gemäß dem Stand der Technik im Querschnitt dargestellt, beispielsweise eine Batteriezelle 100 vom Typ 18650, 20700 oder 2170 (die ersten zwei Ziffern geben den Durchmesser D in der Einheit Millimeter und die letzten zwei bis drei Ziffern geben die Höhe H der Batteriezelle 100 an). Die Batteriezelle 100 weist ein metallisches Batteriezellgehäuse 101, vorteilhafterweise umfassend Aluminium und/oder Stahl, insbesondere vernickelter Stahl, und/oder zylindrisch als eine Dose ausgeformt, sowie eine äußere elektrische Zellisolierung 102 auf. Das metallische Batteriezellgehäuses 101 weist in seinem Inneren die Zellchemikalien 150 auf, das heißt vorteilhafterweise mindestens eine Kathode und eine Anode mit den jeweiligen metallischen Ableitern, welche beispielsweise als Zellwickel vorliegen. Das metallische Batteriezellgehäuses 101 dichtet die Zellchemikalien 150 gegenüber der Umgebung 190 der Batteriezelle 100 ab, wobei zusätzlich ein Deckel 101b vorgesehen ist, welcher mittels einer ringförmigen Dichtung 151 das metallische Batteriezellgehäuses 101 verschließt. Die äußere elektrische Zellisolierung 102 umhüllt das Batteriezellgehäuse 101 und umfasst vorzugsweise einen Schrumpfschlauch aus einem Polymermaterial, beispielsweise weist der Schrumpfschlauch Polyolefine und/oder Polyvinylidenfluorid (PVDF) und/oder Polyvinylchlorid (PVC) auf. Die äußere elektrische Zellisolierung 102 isoliert das Batteriezellgehäuse 101 elektrisch gegenüber der Umgebung 190 der Batteriezelle 100. Die äußere elektrische Zellisolierung 102 weist vorteilhafterweise eine Dicke zwischen 20 µm bis 500 µm, insbesondere zwischen 100 µm bis 200µm auf, auf. Die Batteriezelle 100 weist ferner einen ersten elektrischen Pol 103 (Pluspol) und einen zweiten elektrischen Pol 104 (Minuspol) auf, wobei der zweite elektrische Pol 104 mit dem metallischen Batteriezellgehäuse 101 elektrisch verbunden ist. Vorteilhafterweise umfasst das Batteriezellgehäuse 101 den zweiten elektrische Pol 104. Der Deckel des 101b des metallischen Batteriezellgehäuses 101 umfasst vorteilhafterweise den ersten elektrischen Pol 103.

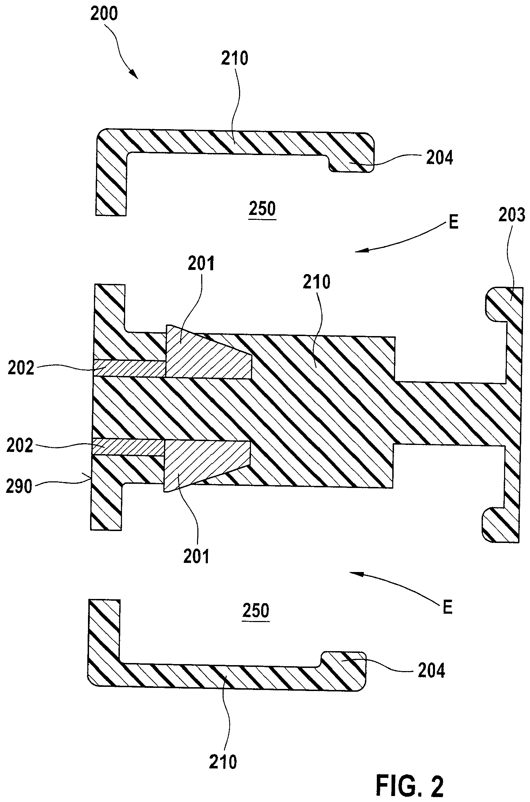

In Figur 2 ist ein Batteriezellhalter 200 im Querschnitt schematisch dargestellt. Der Batteriezellhalter 200 weist eine Polymermatrix 210 auf. Der Batteriezellhalter 200 weist ferner eine Vielzahl an Aufnahmepositionen 250 auf, wobei in Figur 2 beispielshaft zwei Aufnahmepositionen 250 dargestellt sind. Die Aufnahmepositionen 250 umfassen in diesem Beispiel Vertiefungen der Polymermatrix 210. Der Batteriezellhalter 200 ist dazu eingerichtet, jeweils eine Batteriezelle 100 in jeder Aufnahmeposition 250 aufzunehmen. Die Aufnahme erfolgt beispielsweise durch Einfügen der Batteriezellen 100 entlang der dargestellten Fügepfeile E. Der Batteriezellhalter 200 umfasst in jeder Aufnahmeposition 250 eine metallische Schneide 201, welche beispielsweise von der Polymermatrix 210 teilweise umschlossen wird beziehungsweise von der Polymermatrix 210 gehalten wird. Es kann vorgesehen sein, dass mittels einer Feder (nicht dargestellt) eine Federkraft auf die metallischen Schneiden 201 in Richtung der Aufnahmeposition 250 ausgeübt wird. Die Schneide 201 ist vorteilhafterweise scharfkantig und weist gegenüber der Polymermatrix einen Überstand in Richtung der Aufnahmeposition von vorteilhafterweise zwischen 50 µm bis 500 µm, insbesondere zwischen 100 µm bis 250µm auf, auf. Der Batteriezellhalter 200 ist mittels der Schneide 201 dazu eingerichtet, beim Einfügen der Batteriezelle 100 in einer Aufnahmeposition 250 die äußere elektrische Zellisolierung 102 der Batteriezelle 100 zu zerschneiden und optional das metallische Batteriezellgehäuse 101 der Batteriezelle 100 anzuritzten. Die aufgenommene Batteriezelle 100 kontaktiert die metallische Schneide 201 elektrisch. Durch das optionale Anritzten des metallischen Batteriezellgehäuse 101 beim Einfügen 350 der Batteriezelle 100 wird eine zusätzliche Sollberststelle des metallischen Batteriezellgehäuse 101 entlang der Mantelfläche des metallischen Batteriezellgehäuse 101 erzeugt, wobei diese Sollberststelle eine mechanische Wirkung einer Explosion der Batteriezelle 100 in einem Notfall reduziert. Die Polymermatrix 210 umfasst ferner ein erstes Federelement 203 und ein zweites Federelement 204. Das erste und zweite Federelement 203 und 204 sind dazu eingerichtet, Toleranzen einer Batteriezelle 100 auszugleichen und/oder eine Batteriezelle 100 in einer Aufnahmeposition 250 zu fixieren und/oder den elektrischen Kontakt zwischen dem Batteriezellgehäuse 101 und der Schneide 201 zu gewährleisten, wobei der Batteriezellhalter 200 mittels des ersten Federelements 203 und/oder des zweiten Federelements 204 eine Kraft auf die Batteriezelle 100 in Richtung der Aufnahmeposition 250 auszuüben. Der Batteriezellhalter 200 ist mit anderen Worten dazu eingerichtet, die Batteriezelle 100 mit ihrem Batteriezellgehäuse 101 gegen die Schneide 201 zu drücken. Jede der Schneiden 201 ist mit einem elektrischen Leiter 202 verbunden. Der jeweilige elektrische Leiter 202 ist beispielsweise mit einem Steckkontakt verbunden (nicht dargestellt) oder der elektrische Leiter 202 kann mit einem Schweiß- oder Lötkontakt leicht kontaktiert werden, so dass eine elektrische Kontaktierung des elektrischen Leiters 202 an einer Außenseite 290 des Batteriezellhalters 200 erfolgt.

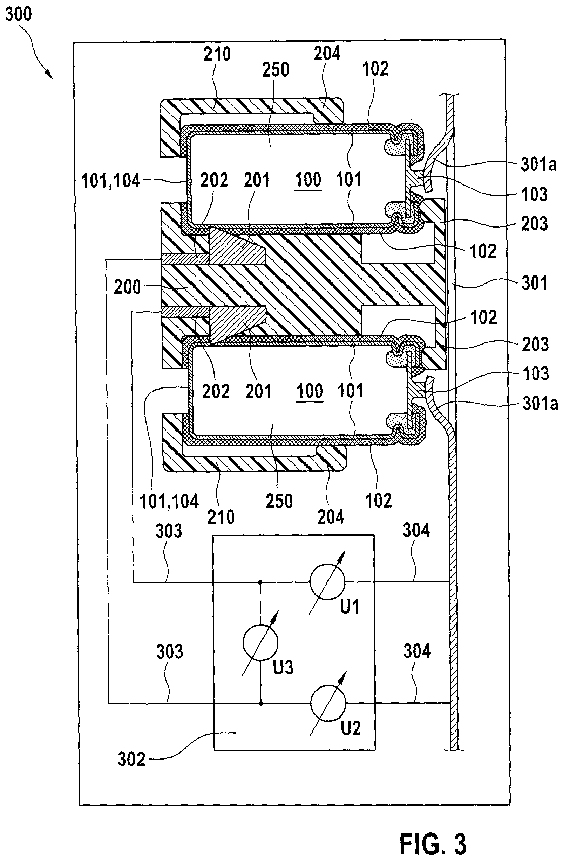

In Figur 3 ist ein Batteriemodul 300 mit dem Ausführungsbeispiel des Batteriezellhalters 200 aus Figur 2 dargestellt. Das Batteriemodul 300 umfasst den Batteriezellhalter 200, die Batteriezellen 100 sowie eine Stromsammelschiene 301 und ein Elektronikmodul 302. In jeder Aufnahmeposition 250 des Batteriezellhalters 200 ist jeweils eine Batteriezelle 100 durch Einfügen der Batteriezelle 100 aufgenommen. Die aufgenommenen Batteriezellen 100 kontaktieren mit ihrem Batteriezellgehäuse 101 jeweils eine metallische Schneide 201 des Batteriezellhalters 200, wobei die Schneide 201 von einer Polymermatrix 210 teilweise umschlossen und mit einem elektrischen Leiter 202 elektrisch verbunden ist. Das Batteriezellgehäuse 101 umfasst den zweiten elektrischen Pol 104 der Batteriezelle 100, welcher von einer weiteren Stromsammelschiene kontaktiert ist (nicht dargestellt). Die elektrischen Leiter 202 kontaktieren jeweils an der Außenseite 290 des Batteriezellhalters Leitungen 303. Die Leitungen 303 verbinden die Batteriezellen 100 über die Schneiden 201 und die elektrischen Leiter 202 des Batteriegehäuses 200 mit dem Elektronikmodul 302. Ferner ist die Stromsammelschiene 301 elektrisch jeweils mit dem ersten elektrischen Pol 103 einer Auswahl an Batteriezellen 100 oder mit dem ersten elektrischen Pol 103 aller Batteriezellen 100 verbunden. Die elektrische Verbindung zwischen der Stromsammelschiene 301 und den Batteriezellen 100 wird durch Federkontakte 301a der Stromsammelschiene 301 erzeugt, wobei der elektrische Kontakt alternativ oder zusätzlich durch andere Kontaktiertechniken wie Schweißen, Drahtbonden oder Löten erfolgt. Die Stromsammelschiene 302 des Batteriemoduls 300 ist dazu eingerichtet, beim Entladen oder Laden des Batteriemoduls 300 einen elektrischen Strom der kontaktierten Batteriezellen 100 zuzuführen und/oder abzuführen. Die Stromsammelschiene 302 ist ferner mit dem Elektronikmodul 302 verbunden. Das Elektronikmodul 302 ist somit dazu eingerichtet, eine Spannung U1 beziehungsweise U2 einer Batteriezelle 100 zu erfassen beziehungsweise eine Einzelzellüberwachung der Batteriezelle 100 in einer Aufnahmeposition 250 durchzuführen. Zur Einzelzellüberwachung wird eine elektrische Spannung U1, U2 zwischen der Stromsammelschiene 302 und einem elektrischen Leiter 202 und/oder eine elektrische Spannung U3 zwischen zwei verschiedenen elektrischen Leitern 202 des Batteriezellhalters 200 erfasst.

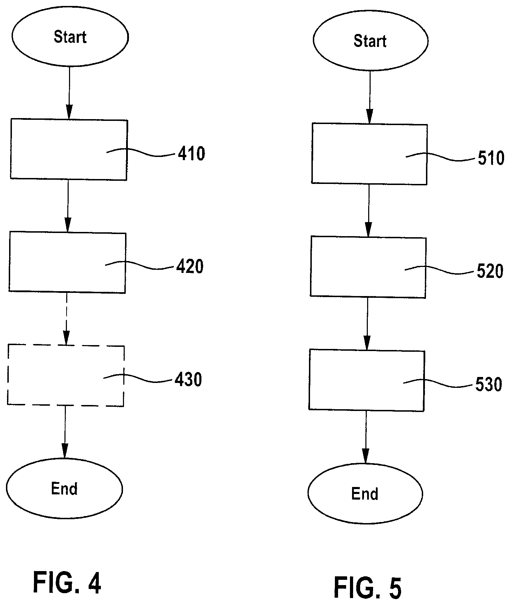

Figur 4 zeigt ein Ablaufdiagramm eines Fertigungsverfahrens eines Batteriezellhalters 200 als Blockschaltbild. In einem Schritt 410 werden eine Vielzahl an metallischen Schneiden 201 bereitgestellt. Die Bereitstellung 410 der Vielzahl an Schneiden 201 erfolgt optional durch ein metallisches Stanzgitter, welches die Schneiden 201 und optional die elektrischen Leiter 202 umfasst. Anschließend erfolgt eine teilweise Umspritzung 420 der metallischen Schneiden 201 in einer Spritzgussform zur Herstellung der Polymermatrix 210 des erfindungsgemäßen Batteriezellhalters 200. Im Falle der Verwendung eines Stanzgitters ist nach der Umspritzung 420 optional vorgesehen, eine Trennung 430 der metallischen Verbindungen des Stanzgitters zwischen den metallischen Schneiden 201 und/oder den elektrischen Leitern 202 durchzuführen.

In Figur 5 ist ein Ablaufdiagramm eines Montageverfahrens des Batteriemoduls als Blockschaltbild dargestellt. In einem Schritt 510 werden eine Vielzahl an Batteriezellen 100 bereitgestellt. Jede Batteriezelle 100 weist das metallische Batteriezellgehäuse 101 auf, welches zumindest zum Teil durch die äußere elektrische Zellisolierung 102 umhüllt ist. Außerdem wird der Batteriezellhalter 200 bereitgestellt, wobei der Batteriezellhalter 200 dazu eingerichtet ist, die Batteriezellen 100 in jeweils einer Aufnahmeposition 250 aufzunehmen. Jede der Aufnahmepositionen 250 umfasst die metallische Schneide 201. In einem weiteren Schritt 530 des Montageverfahrens werden die bereitgestellten Batteriezellen 100 in jeweils eine Aufnahmeposition 250 des bereitgestellten Batteriezellhalters 200 eingefügt, wobei die Schneide 201 der Aufnahmeposition 250 die äußere elektrische Zellisolierung 102 der Batteriezelle 100 durchschneidet und ein elektrischer Kontakt zwischen dem metallischen Batteriezellgehäuse 101 der aufgenommenen Batteriezelle 100 und der metallischen Schneide 201 des Batteriezellhalters 200 erzeugt wird. Optional ritzt die Schneide 201 des Batteriezellhalters 200 das metallische Batteriezellgehäuse 101 der Batteriezelle 100 beim Einfügen 530 der bereitgestellten Batteriezelle 100 in einer der Aufnahmepositionen 250 des Batteriezellhalters 200 an.

## Patentansprüche

1. Batteriezellhalter (200), aufweisend
• eine Vielzahl an Aufnahmepositionen (250), wobei jede Aufnahmeposition (250) dazu eingerichtet ist, eine Batteriezelle (100) aufzunehmen,
**dadurch gekennzeichnet, dass**
• jede Aufnahmeposition (250) mindestens eine metallische Schneide (201) aufweist, wobei die Schneide (201) dazu eingerichtet ist, beim Einfügen (530) einer Batteriezelle (100) in die Aufnahmeposition (250) eine äußere elektrische Zellisolierung (102) der Batteriezelle (100) zu durchschneiden und einen elektrischen Kontakt zwischen einem metallischen Batteriezellgehäuse (101) der aufgenommenen Batteriezelle (100) und der Schneide (201) zu erzeugen.

2. Batteriezellhalter (200) nach Anspruch 1, **dadurch gekennzeichnet, dass** der Batteriezellhalter (200) folgende Komponenten aufweist
• eine Vielzahl an elektrischen Leitern (202), wobei jeder elektrische Leiter (202) mit einer Schneide (201) einer Aufnahmeposition (250) verbunden ist.

3. Batteriezellhalter (200) nach Anspruch 2, **dadurch gekennzeichnet, dass** die elektrischen Leiter (202) und/oder die Schneiden (201) im Batteriezellhalter (200) von einer Polymermatrix (210) zumindest teilweise umschlossen sind.

4. Batteriezellhalter (200) nach einem der vorhergehenden Ansprüche, **dadurch gekennzeichnet, dass** die Schneide (201) zusätzlich dazu eingerichtet ist, das metallische Batteriezellgehäuse (101) der Batteriezelle (100) beim Einfügen (530) der Batteriezelle (100) anzuritzen.

5. Batteriezellhalter (200) nach einem der vorhergehenden Ansprüche, **dadurch gekennzeichnet, dass** jede Aufnahmeposition (250) mindestens ein Federelement (203, 204) aufweist, welches dazu eingerichtet sind, die aufgenommene Batteriezelle (100) in der Aufnahmeposition (250) zu fixieren.

6. Batteriemodul, aufweisend
• eine Vielzahl an Batteriezellen (100), und
• ein Batteriezellhalter (200) nach einem der Ansprüche 1 bis 5, wobei jede Batteriezelle (100) in einer Aufnahmeposition (250) des Batteriezellhalters (200) aufgenommen ist, wobei die Batteriezelle (100) mit einem metallischen Batteriezellgehäuse (101) der Batteriezelle (100) eine metallische Schneide (201) des Batteriezellhalters (200) elektrisch kontaktiert.

7. Batteriemodul (300) nach Anspruch 6, **dadurch gekennzeichnet, dass** das Batteriemodul (300) folgende Komponenten umfasst
• eine metallische Stromsammelschiene (301), welche dazu eingerichtet ist, jede Batteriezelle (100) an einem ersten elektrischen Pol (103) der Batteriezelle (100), welcher nicht mit dem metallischen Batteriezellgehäuse (101) der Batteriezelle (100) verbunden ist, zu kontaktieren, und
• ein Elektronikmodul (302), welches dazu eingerichtet ist, eine elektrische Spannung (U1, U2) zwischen der Stromsammelschiene (301) und einem elektrischen Leiter (202) und/oder eine elektrische Spannung (U3) zwischen zwei verschiedenen elektrischen Leitern (202) des Batteriezellhalters (200) zu erfassen, wobei jeder elektrische Leiter (202) des Batteriezellhalters (200) mittels einer jeweiligen Schneide (201) mit dem metallischen Batteriezellgehäuse (101) einer Batteriezelle (100) des Batteriemoduls (300) elektrisch leitfähig verbunden ist.

8. Fertigungsverfahren eines Batteriezellhalters (200), aufweisend folgende Schritte
• Bereitstellung (410) einer Vielzahl von metallischen Schneiden (201), und
• Umspritzung (420) der metallischen Schneiden (201) in einer Spritzgussform zur Herstellung einer Polymermatrix (210) des Batteriezellhalters (200) nach einem der Ansprüche 1 bis 5.

9. Fertigungsverfahren nach Anspruch 8, **dadurch gekennzeichnet**, das ein metallisches Stanzgitter die Schneiden (201) und elektrische Leiter (202), welche jeweils mit einer Schneide (201) elektrisch leitfähig verbunden sind, umfasst.

10. Fertigungsverfahren nach Anspruch 9, **dadurch gekennzeichnet, dass** nach der Umspritzung (420) der folgende Schritt durchgeführt wird
• Trennung (430) der metallischen Verbindungen des Stanzgitters zwischen den metallischen Schneiden (201) und/oder elektrischen Leitern (202).

11. Montageverfahren eines Batteriemodus, aufweisend den folgenden Schritt
• Bereitstellung (510) einer Vielzahl an Batteriezellen (100), wobei jede Batteriezelle (100) ein metallisches Batteriezellgehäuse (101) aufweist, welches zumindest zum Teil durch eine äußere elektrische Zellisolierung (102) umhüllt ist, **dadurch gekennzeichnet, dass** die folgenden Schritte durchgeführt werden
• Bereitstellung (520) eines Batteriezellhalters (200), wobei der Batteriezellhalter (200) dazu eingerichtet ist, die Batteriezellen (100) in jeweils einer Aufnahmeposition (250) aufzunehmen, wobei jede der Aufnahmepositionen (250) eine metallische Schneide (201) aufweist, und
• Einfügen (530) der bereitgestellten Batteriezellen (100) in jeweils eine Aufnahmeposition (250) des bereitgestellten Batteriezellhalters (200), wobei die Schneide (201) der Aufnahmeposition (250) die äußere elektrische Zellisolierung (102) der Batteriezelle (100) durchschneidet und ein elektrischer Kontakt zwischen dem metallischen Batteriezellgehäuse (101) der aufgenommenen Batteriezelle (100) und der metallischen Schneide (201) des Batteriezellhalters (200) erzeugt wird.

12. Montageverfahren nach Anspruch 11, **dadurch gekennzeichnet, dass** die Schneide (201) des Batteriezellhalters (200) das metallische Batteriezellgehäuse (101) der Batteriezelle (100) beim Einfügen (530) der bereitgestellten Batteriezelle (100) in einer der Aufnahmepositionen (250) des Batteriezellhalters (200) anritzt.
